(19) Europäisches Patentamt
European Patent Office
Office européen des brevets

(11) Numéro de publication: **0 207 551**
**A1**

(12) **DEMANDE DE BREVET EUROPEEN**

(21) Numéro de dépôt: 86201033.7

(51) Int. Cl.[4]: **G 03 F 7/10**

(22) Date de dépôt: 16.06.86

(30) Priorité: 18.06.85 FR 8509219

(43) Date de publication de la demande:
07.01.87 Bulletin 87/2

(84) Etats contractants désignés:
DE FR GB

(71) Demandeur: Laboratoires d'Electronique et de Physique Appliquée L.E.P.
3, Avenue Descartes BP 15
F-94451 Limeil-Brévannes(FR)

(84) Etats contractants désignés:
FR

(71) Demandeur: N.V. Philips' Gloeilampenfabrieken
Groenewoudseweg 1
NL-5621 BA Eindhoven(NL)

(84) Etats contractants désignés:
DE GB

(72) Inventeur: Collet, André
Société Civile S.P.I.D. 209 rue de l'Université
F-75007 Paris(FR)

(72) Inventeur: Gourrier, Serge
Société Civile S.P.I.D. 209 rue de l'Université
F-75007 Paris(FR)

(72) Inventeur: Maurin, Olivier
Société Civile S.P.I.D. 209 rue de l'Université
F-75007 Paris(FR)

(74) Mandataire: Landousy, Christian et al,
Société Civile S.P.I.D. 209, Rue de l'Université
F-75007 Paris(FR)

(54) **Composition pour obtenir une résine photosensible de haute résolution développable par plasma et procédé photolithographique mettant en oeuvre cette résine.**

(57) Composition pour une résine photosensible de haute résolution développable par plasma incluant un polymère et un composé photosensible, le polymère étant de la famille des polymères acryliques et/ou poly(cétones vinyliques) et le composé photosensible étant de la famille des azides aromatiques, caractérisée en ce que le polymère contient en outre dans une chaine latérale au moins un noyau aromatique sur lequel au moins un atome de chlore (Cl⁻) a été substitué à au moins un atome d'hydrogéne (H⁻), comme par exemple :

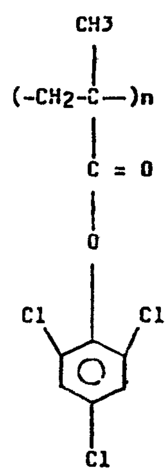

ou

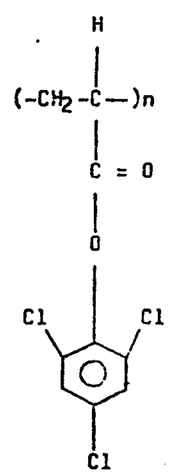

*Application* : Masques de résolution submicronique pour la réalisation de microcircuits semiconducteurs

EP 0 207 551 A1

Croydon Printing Company Ltd.

COMPOSITION POUR OBTENIR UNE RESINE PHOTOSENSIBLE DE HAUTE RESOLUTION, DEVELOPPABLE PAR PLASMA ET PROCEDE PHOTOLITHOGRAPHIQUE METTANT EN OEUVRE CETTE RESINE

L'invention concerne une composition pour une résine photosensible de haute résolution développable par plasma, incluant un polymère et un composé photosensible, le polymère étant de la famille des polymères acryliques et/ou polycétones vinyliques et le composé photosensible étant de la famille des azides aromatiques.

L'invention trouve son application dans la réalisation par plasma, de motifs de dimensions inférieures au micron dans une couche de résine, après irradiation localisée de cette résine à l'aide d'un rayonnement électromagnétique ou d'un faisceau de particules, de manière à constituer des masques utilisés lors des différentes étapes de la fabrication des microcircuits à haute densité d'intégration.

L'invention concerne également le procédé d'obtention de cette résine, et le procédé photolithographique mettant en oeuvre cette résine.

Une résine telle que décrite dans le préambule est connue du brevet US-4 401 745. Ce document décrit une famille de résines formées d'un polymère et d'un composé photosensible, dans lesquelles le polymère appartient à la catégorie des polymères acryliques et/ou poly(cétones vinyliques) de poids moléculaires compris entre $10^4$ et $2.10^6$ et dans lesquelles le composé photosensible est un monomère de la famille des azides aromatiques. Ce document mentionne en outre la possibilité d'ajouter un troisième constituant sous la forme d'un composé vinylique.

Les résines décrites dans le document cité sont du genre négatif, c'est-à-dire que l'agent de développement attaque préférentiellement les parties non irradiées.

Ces résines sont utilisées de la façon suivante :

après dépôt sur un substrat, la résine choisie dans la famille citée plus haut, est irradiée localement selon un motif prédéterminé, à l'aide de rayons ultra-violets, de rayons X ou d'un faisceaux d'électrons. Puis elle est soumise à un développement par voie sèche à l'aide d'un plasma incluant soit l'oxygène, soit $CF_4$, soit le mélange $CF_4$-$O_2$, soit encore le mélange $O_2$-Ar. Les parties non irradiées sont donc attaquées préférentiellement par ces plasmas. On forme ainsi localement des ouvertures dans la couche de résine. Les masques ainsi constitués sont utilisés en photolithographie dans les procédés de réalisation des circuits intégrés.

Or les éléments des microcircuits sont, à ce jour, de l'ordre de, ou même inférieurs au micromètre (/um). Dans ces conditions, les motifs formés dans les résines utilisées en photolithographie doivent être du même ordre de grandeur. C'est pourquoi les qualités des résines doivent être optimisées particulièrement en ce qui concerne la résolution, la sensibilité et la sélectivité.

Par résolution, il faut entendre la taille minimale des motifs que l'on peut définir à l'aide de la résine, par sensibilité, il faut entendre la dose minimale d'irradiation nécessaire pour obtenir une modification chimique de la résine, suffisant au développement, et enfin par sélectivité, il faut entendre la différence des vitesses d'attaque entre zone irradiée et zone non irradiée.

Les procédés photolithographiques qui incluent l'utilisation de résines développables par voie sèche, c'est-à-dire par plasma, telles que la famille de résines connues du document cité, présentent sur les procédés qui incluent des résines développables par voie humide, c'est-à-dire dans un bain de développeur, de nombreux avantages. En particulier, ces procédés offrent la possibilité de traiter de nombreux échantillons avec une meilleure reproductibilité. Ils offrent de plus la possibilité d'intégrer l'étape de développement de la résine dans un cycle complet de réalisation d'éléments de

microcircuits sous vide. Ils offrent en outre la possibilité d'optimiser le contraste en améliorant l'anisotropie de gravure par un contrôle judicieux des paramètres du plasma. Ils offrent enfin la possibilité de bénéficier d'une bonne sensibilité, propriété inhérente aux résines négatives, sans être limité en résolution, ce qui est le cas lorsque les résines négatives sont développées en voie humide, cette perte de résolution étant alors dûe à un phénomène de "gonflement" imputable au développeur.

Pour répondre aux besoins de l'industrie en circuits intégrés toujours plus performants et présentant une densité d'intégration toujours plus grande, la présente invention propose une résine photosensible qui est dotée des qualités précédemment citées et qui présente en outre une résolution et une sensibilité améliorées par rapport à la résine connue du document cité.

Selon la présente invention, ce but est atteint au moyen d'une composition telle que décrite dans le préambule, caractérisée en ce que le polymère contient en outre dans une chaîne latérale au moins un noyau aromatique sur lequel au moins un atome de chlore (Cl) a été substitué à au moins un atome d'hydrogène (H).

Ce type de polymère présente alors de nombreux avantages. Tout d'abord, cette catégorie de polymères présente une vitesse d'attaque en plasma d'oxygène plus grande que celle des polymères précédemment connus, ce qui améliore la sélectivité.

Par contre ces polymères montre une bonne résistance à l'attaque par les autres plasmas tels que $CF_4$ ou bien $CF_4 + O_2$ qui sont précisément des plasmas utilisés pour l'attaque des substrats dans l'élaboration des microcircuits. Cette propriété permet d'envisager des gravures sélectives entre la résine et les substrats.

Enfin la présence d'atomes de chlore dans la structure du polymère conduit à une forte absorption pour

certaines longueurs d'onde dans le domaine des rayons X, ce qui a pour effet d'améliorer la sensibilité à ce type de radiation.

La description qui va suivre fera mieux comprendre comment l'invention est réalisée.

La composition de la résine selon l'invention inclut tout d'abord un polymère qui peut être par exemple un polymère acrylique et/ou polycétone vinylique.

Selon la présente invention ce polymère est tel qu'il inclut, dans une chaîne latérale, un noyau aromatique dans lequel un ou plusieurs atomes de chlore (Cl) sont substitués à un ou plusieurs atomes d'hydrogène (H).

On citera à titre d'exemple non limitatif d'un tel polymère le poly(2,4,6 - trichlorophénylméthacrylate) (PT C Ph MA) de formule (1)

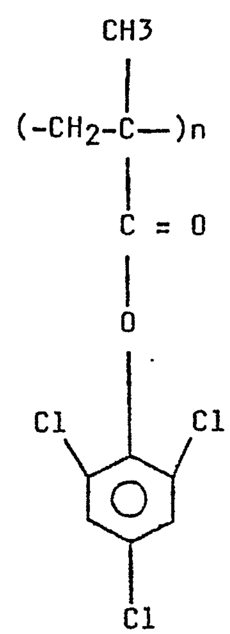

(1)

ou bien le poly(2,4,6 -trichlorophenylacrylate) (PT C Ph A) de formule (2)

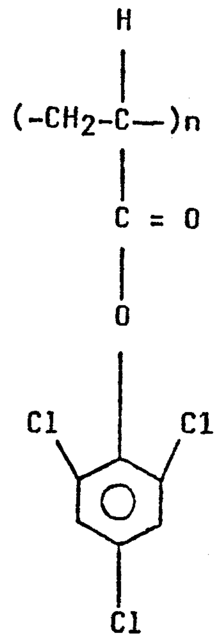

(2)

et leurs copolymères avec le méthacrylate de méthyle et l'acrylate de méthyle.

Cette composition inclut en outre un composé photosensible du type azide aromatique dont les formules générales sont données en (3,4,5,6,7,8,9,10,11).

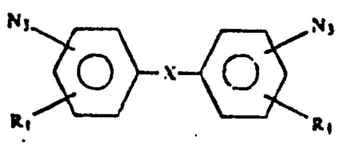

(3)

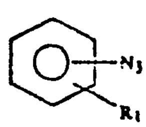

(4)

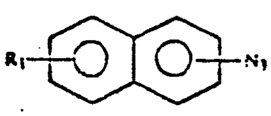

(5)

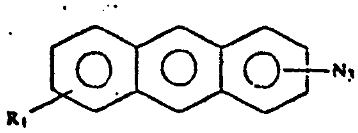

(6)

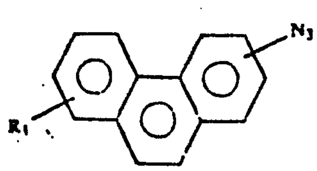

(7)

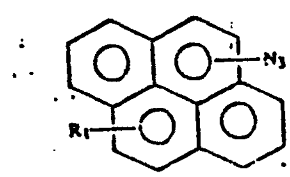

(8)

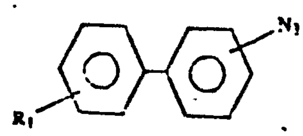

(9)

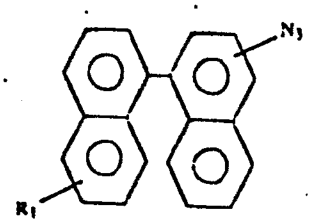

(10)

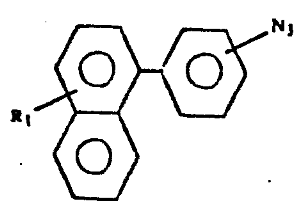

(11)

formules dans lesquelles, ceci étant donné à titre d'exemples non limitatifs,

X représente : -O-, -NH-, -CO-, $-CH_2-$, -S-, $-SO_2-$, -CH = CH-, -CH = CH- CO-CH = CH-, -CH = CH-CO-, ou bien (12,13)

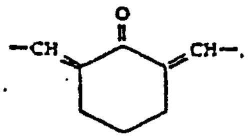 (12) ou encore 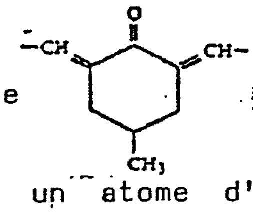 (13) et dans lesquelles

$R_1$ représente : un atome d'hydrogène, un atome d'halogène, un groupe azide, un groupe alkyl, ou un groupe alkylhalogène.

Des exemples particuliers sont le : 1-amino-5-azidonaphtalène, le 4,4' -diazidodiphénylsulfone, ou le 2-6-di(4'-azidobenzilidène)-4-méthylcyclohexanone.

Lors d'un procédé photolithographique mettant en oeuvre la résine ainsi constituée, cette dernière est déposée sur un substrat semi-conducteur, puis pré-cuite afin d'éliminer le solvant. La couche de résine est alors soumise à une irradiation à travers un masque. Les azides qui entrent dans la composition de la résine selon l'invention sont des composés photosensibles dans le domaine des ultra-violets. Une irradiation de cette résine à l'aide d'un rayonnement ultraviolet est donc particulièrement efficace. Cependant, l'utilisation de ce type de rayonnement n'est pas limitative.

En effet, la présence de chlore dans la structure du polymère conduit à une très bonne sensibilité aux rayons X pour certaines longueurs d'onde. Enfin l'irradiation par électrons peut aussi être employée dans le cadre de l'invention.

L'irradiation provoque la fixation du composé photosensible sur le polymère avec formation d'amines aromatiques secondaires possédant des propriétés fortement anti-oxydantes.

Après irradiation, l'échantillon ainsi constitué subit une "post-cuisson". Cette phase est essentielle pour éliminer l'azide des zones non insolées, alors que dans les zones insolées les amines secondaires restent fixées au

polymère. La température de post-cuisson est fonction de l'azide utilisée.

A ce stade, l'échantillon est alors prêt à subir le développement par plasma.

Selon le document cité comme art antérieur, il est spécifié que le polymère ne doit contenir aucun noyau aromatique et ceci ni dans la chaîne principale ni dans une chaîne latérale. Cette spécification est parfaitement fondée, car les polymères qui contiendraient de tels noyaux montreraient une faible vitesse d'attaque en plasma d'oxygène, ce qui conduirait à une mauvaise sélectivité.

Par contre, selon la présente invention, le polymère inclut dans une chaîne latérale au moins un noyau aromatique dans lequel un (ou plusieurs) atome(s) de chlore est (sont) substitués à un (ou plusieurs) atome(s) d'hydrogène. Dans ces conditions, la vitesse d'attaque du polymère en plasma d'oxygène devient très forte et la sélectivité de la résine s'en trouve nettement améliorée, et ceci d'autant plus que les zones irradiées possèdent comme on l'a vu, de fortes propriétés anti-oxydantes, donc une très faible vitesse d'attaque en plasma d'oxygène.

Le plasma d'oxygène sera donc utilisé de façon préférentielle dans la mise en oeuvre d'un procédé photolithographique à l'aide de la résine selon l'invention. D'autre part cette dernière montre une résistance remarquable à l'attaque par plasma $CF_4 + O_2$. Ceci procure l'avantage de permettre au cours du procédé photolithographique, des attaques sélectives. En effet le plasma $CF_4 + O_2$ est précisément très utilisé pour graver les substrats semiconducteurs lors de certaines étapes de l'élaboration des microcircuits.

Les proportions respectives, dans la composition de la résine, entre le polymère et le composé photosensible sont fixées en tenant compte de deux paramètres :

- la compatibilité entre le polymère, le composé photosensible et le solvant,

- les propriétés d'absorption du composé photosensible vis-à-vis du rayonnement utilisé.

Exemple de composition et de mise en oeuvre de la résine

Une résine conforme à l'invention peut être réalisée à l'aide de :

- 500 mg de polytrichlorophénylmétacrylate (PTC Ph MA) choisi comme polymère, de masse moléculaire de $216.10^3$ dissous dans un mélange de $5cm^3$ de chlorobenzène et $0,6cm^3$ de NN-diméthylacétamide, utilisé dans cet exemple comme solvant ;

- 75 mg de diazidophenylsulfone choisi comme composé photosensible.

Après dissolution, une épaisseur de l'ordre de 150 nm est déposée par une opération dite "à la tournette" sur une plaquette de matériau semiconducteur destinée à servir de substrat pour une circuit intégré.

L'échantillon ainsi constitué est pré-cuit à une température de 90°C sous azote pendant une durée de 30 mn, de manière à éliminer correctement le solvant.

Puis l'échantillon subit une irradiation selon le dessin prévu pour les éléments de microcircuit qui doivent être réalisés sur le substrat. Cette irradiation peut être faite à l'aide d'un rayonnement ultra-violet de longueur d'onde $\lambda = 310$ nm. Les doses de rayonnement peuvent être comprises dans la fourchette de 90 $mJ/^2$ à 180 $mJ/m^2$.

A la suite, l'échantillon est post-cuit à environ 140°C sous azote pendant environ 30 mn. Comme il a été dit, durant cette opération l'azide est éliminé des zones non-insolées.

L'échantillon est enfin placé dans une chambre à plasma. Dans l'exemple décrit ici, la chambre à plasma est du type diode. Le diamètre des électrodes est d'environ 10 cm et leur écartement d'envirion 3 cm.

Durant l'attaque par plasma :

- la pression est environ $7.10^{-1}$ Torr,
- le débit d'oxygène est environ 100 cc/mn,

- la puissance 100 W
- la température 190°C

Dans l'état de la technique auquel l'invention aboutit, la résolution n'est plus limitée que par les masques qui délimitent les zones irradiées et non irradiées.

C'est pourquoi la résolution est de l'ordre de 0,2/um. une vitesse d'attaque de l'ordre de 160 nm/seconde a été observée dans les zones non irradiées, contre une vitesse d'attaque de 70 nm/seconde dans les zones irradiées.

Selon la présente invention, la vitesse d'attaque des zones non irradiées est donc 2 fois plus grande que celle des zones irradiées. L'épaisseur résiduelle dans ces zones est, compte tenu du retrait après post-cuisson, d'environ 75 % de l'épaisseur initiale, ce qui améliore toutes les qualités de la résine : sensibilité, résolution,etc...

De plus le PTCPhMA utilisé dans cet exemple de mise en oeuvre est particulièrement résistant à l'attaque du plasma $CF_4$ + $O_2$ pour lequel la vitesse d'attaque est de l'ordre de 4,4 nm/mn à températeur ambiante. Ce plasma peut alors être utilisé pour la gravure du substrat semiconducteur par les ouvertures délimitées dans la résine à l'aide de la gravure par plasma d'oxygène déjà décrite.

REVENDICATIONS :

1. Composition pour une résine photosensible de haute résolution développable par plasma incluant un polymère et un composé photosensible, le polymère étant de la famille des polymères acryliques et/ou poly(cétones vinyliques) et le composé photosensible étant de la famille des azides aromatiques, caractérisée en ce que le polymère contient en outre dans une chaîne latérale au moins un noyau aromatique sur lequel au moins un atome de chlore ($Cl^-$) a été substitué à au moins un atome d'hydrogène ($H^-$).

2. Composition selon la revendication 1, caractérisée en ce que le polymère est le poly(2,4,6-trichlorophénylméthacrylate) (PTCPhMA) de formule :

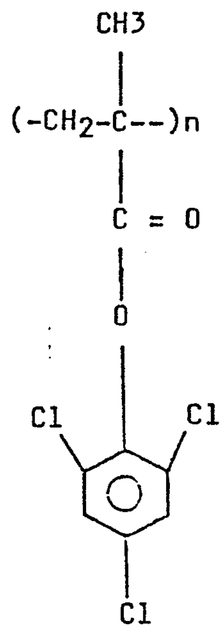

ou ses homologues mono, di ou trichlores.

3. Composition selon la revendication 1, caractérisée en ce que le polymère est le poly(2,4,6-trichlorophénylacrylate) (PTCPhA) de formule :

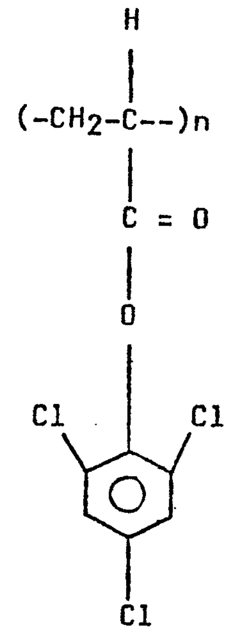

ou ses homologues mono, di ou trichlores.

4. Composition selon la revendication 1, caractérisée en ce que le polymère est choisi parmi le poly(2,4,6-trichlorophénylmétracrylate-co-méthacrylate de méthyle)
ou le
poly(2,4,6-trichlorophénylméthacrylate-co-acrylate de méthyle)
ou le
poly(2,4,6-trichlorophénylacrylate-co-méthacrylate de méthyle)
ou le
poly (2,4,6-trichlorophénylacrylate-co-acrylate de méthyle)
ou les copolymères homologues obtenus à partir des dérivés mono, di ou trichlores.

5. Composition selon l'une des revendications 1 à 4, caractérisée en ce qu'à ce polymère est associé un composé photosensible choisi parmi les azides aromatiques de formule :

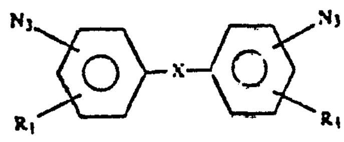

ou bien :

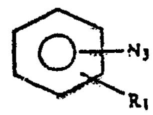

ou bien :

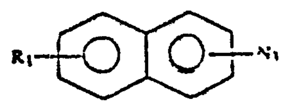

ou bien :

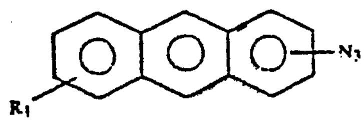

ou bien :

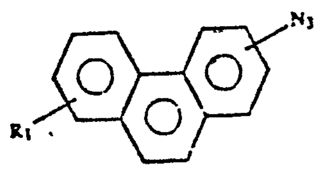

ou bien :

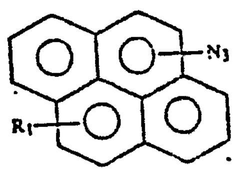

ou bien :

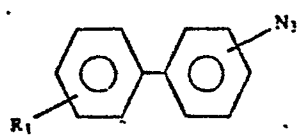

ou bien :

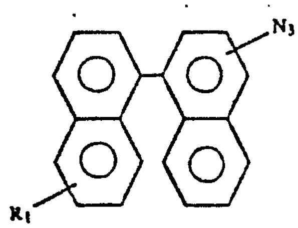

ou bien :

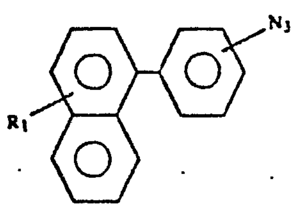

formules dans lesquelles :

X représente : -O-, -NH-, -CO-, $-CH_2-$, -S-, $-SO_2-$, -CH = CH-, -CH = CH-CO-CH = CH-, -CH = CH-CO, ou bien :

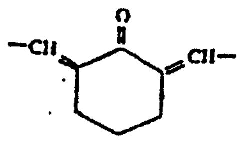

ou bien :

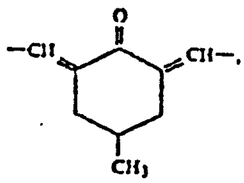

et dans lesquelles :

$R_1$ représente : un atome d'hydrogène, un atome d'hologène, un groupe azide, un groupe alkyl, ou un groupe alkylhalogène.

6. Procédé de réalisation de motifs submicroniques dans une couche de résine photosensible conforme à l'une des revendications 1 à 5, en vue de l'élaboration de microcircuits électroniques, caractérisé en ce qu'il comprend les étapes de :

a) dissolution des quantités appropriées de polymère et de composé photosensible dans un solvant organique, par exemple le chlorobenzène,

b) dépôt d'une couche de la résine ainsi obtenue sur une plaquette de substrat semiconducteur, par exemple de silicium,

c) pré-cuisson à faible température (< 100°C) de manière à éliminer le solvant organique,

d) irradiation de la surface de la couche de résine, à travers un masque, selon les motifs choisis pour le microcircuit, à l'aide d'une radiation choisie entre une radiation de longueur d'onde inférieure à 400 nm, ou bien un faisceau de particules énergétiques comme par exemple des électrons,

e) post-cuisson de l'échantillon irradié de manière à éliminer le composé photosensible des zones irradiées,

f) développement de la résine à l'aide d'un plasma d'oxygène ($O_2$) de manière à éliminer préférentiellement les zones non irradiées et à former dans ces zones des ouvertures dans la couche de résine.

7. Procédé de réalisation de motifs submicroniques dans un substrat semi-conducteur en vue de l'élaboration d'un microcircuit électronique, caractérisé en ce qu'à l'issu d'un procédé conforme à la revendication 6, le substrat semiconducteur est gravé suivant les ouvertures formées dans la couche de résine à l'aide d'un plasma $CF_4 + O_2$.

Office européen des brevets

# RAPPORT DE RECHERCHE EUROPEENNE

0207551

Numero de la demande

EP 86 20 1033

## DOCUMENTS CONSIDERES COMME PERTINENTS

| Catégorie | Citation du document avec indication, en cas de besoin, des parties pertinentes | Revendication concernee | CLASSEMENT DE LA DEMANDE (Int Cl 4) |
|---|---|---|---|
| X,Y | EP-A-0 135 900 (P.A. HUNT)<br>* Page 5, ligne 18 - page 6, ligne 7; revendication * | 1-7 | G 03 F 7/10 |
| Y | JOURNAL OF APPLIED POLYMER SCIENCE, vol. 26, no. 10, octobre 1981, pages 3395-3408, John Wiley & Sons Inc.; KATSUHIRO HARADA: "Dry etching durability of positive electron resists"<br>* En entier * | 1-7 | |
| A | DE-A-3 112 196 (TOKYO OHKA)<br>* Revendications * | 1-7 | |

DOMAINES TECHNIQUES RECHERCHES (Int Cl 4)

G 03 F 7/10

Le present rapport de recherche a ete etabli pour toutes les revendications

| Lieu de la recherche | Date d achèvement de la recherche | Examinateur |
|---|---|---|
| LA HAYE | 25-09-1986 | RASSCHAERT A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire
T : théorie ou principe à la base de l'invention
E : document de brevet antérieur, mais publie à la date de dépôt ou après cette date
D : cité dans la demande
L : cité pour d'autres raisons
& : membre de la même famille, document correspondant